# EUROPÄISCHE PATENTSCHRIFT

(11) **EP 2 701 190 B1**
(45) Veröffentlichungstag und Bekanntmachung des Hinweises auf die Patenterteilung: **31.07.2019**
(21) Anmeldenummer: 13181083.0
(22) Anmeldetag: 20.08.2013
(51) Int. Cl.: H01L 23/473, H01L 21/48

(54) **Verfahren zur Herstellung eines Kühlkörpers für mindestens ein zu kühlendes Bauelement**
Method for manufacturing a cooling unit for at least one component to be cooled
Procédé de fabrication d'un corps de refroidissement pour au moins un élément à refroidir

(30) Priorität: 21.08.2012 DE 102012107684
(43) Veröffentlichungstag der Anmeldung: 26.02.2014
(73) Patentinhaber: Autokühler GmbH & Co. KG, 34369 Hofgeismar (DE)
(72) Erfinder: Kozica, Michael, 34376 Immenhausen (DE)
(74) Vertreter: Kleine, Hubertus

(56) Entgegenhaltungen:
- EP-A2- 1 748 484
- WO-A1-2005/088713
- DE-A1- 19 506 091
- DE-A1-102005 012 501
- DE-U1-202009 005 305
- US-B2- 7 417 857

## Beschreibung

Die vorliegende Erfindung betrifft ein Verfahren zur Herstellung eines Kühlkörpers gemäß dem Oberbegriff des Anspruchs 1.

Gattungsgemäße Kühlkörper, insbesondere sogenannte flüssigkeitsführende Kühlplatten werden in zunehmendem Maße zur Entwärmung von Bauteilen der Leistungselektronik, beispielsweise in Umrichtern von elektrischen Antrieben von Nutzfahrzeugen, Schiffen, Pkws, von Maschinen, beispielsweise Schweißanlagen sowie in Anlagen zur Stromerzeugung wie Windturbinen oder Photovoltaikanlagen eingesetzt. Auch zur Temperierung von Traktionsbatterien werden solche Kühlkörper eingesetzt.

Solche Kühlkörper sind beispielsweise in der EP 1 748 484 A2, der US 7 417 857 B2, der DE 10 2005 012 501 A1, der DE 20 2009 005 305 U1 oder der DE 195 06 091 A1 beschrieben.

Die aus dem Stand der Technik bekannten Kühlkörper bestehen dabei in der Regel aus Aluminiumplatten mit eingepressten Rohren, Strangpressplatten, reibrührgeschweißten Platten oder auch hartgelöteten Platten mit Turbulatoren. Solche gelöteten Kühlkörper mit Turbulatoren besitzen dabei die größte Leistungsdichte und ermöglichen gleichzeitig eine hohe konstruktive Freiheit bei der Zuführung und Verteilung der Kühlflüssigkeit sowie für die Befestigung der zu kühlenden Bauteile wie beispielsweise Leistungshalbleiter.

Als Lötverfahren zum Verlöten solcher Kühlplatten oder Kühlkörper mit Turbulatoren sind das Salzbadlöten, das Vakuumlöten sowie das Schutzgaslöten bekannt. Nachteilig an der Salzbadlötung ist, dass wegen des Zutritts und Ablaufs von Lötflussmitteln keine geschlossenen Strukturen erhalten werden können, sprich, es sind keine flächig dichten Lötungen möglich. Insbesondere bei der Herstellung großer Produktserien ist dieses Verfahren u.a. wegen zahlreicher notwendiger Nacharbeiten außerdem sehr teuer.

Auch das Vakuumlöten ist ein sehr kostenintensives Verfahren, insbesondere bedingt durch die sehr hohen Genauigkeitsanforderungen an die einzusetzenden Materialien und Werkzeuge.

Die Nachteile des Schutzgaslötens bestehen vor allem in einer problematischen Erwärmung bei großen Masseunterschieden der zu verlötenden Bauteile. Außerdem sind aufwändige Spannmittel notwendig.

In der WO 2005/088713 A1 ist ein verlöteter Kühlkörper ohne Turbulatoren aus Kupfer oder einem höherwertigen Metall beschrieben, wobei die Bauteile des Kühlkörpers in mehreren Schritten nacheinander miteinander verlötet werden. Dabei erfolgt das Löten bevorzugt mittes Induktionserwärmung.

Aufgabe der vorliegenden Erfindung ist es, ein Herstellungsverfahren für einen Kühlkörper für mindestens ein zu kühlendes Bauelement bereitzustellen, mit dem ein solcher Kühlkörper kostengünstig hergestellt werden kann und mit dem flächig dichte Lötungen ermöglicht werden.

Die gestellte Aufgabe wird durch ein Verfahren zur Herstellung eines Kühlkörpers mit den Merkmalen des Anspruchs 1 gelöst.

Das erfindungsgemäße Verfahren zur Herstellung eines Kühlkörpers mit zumindest einer Grundplatte, einer Deckplatte sowie einer zwischen der Grundplatte und der Deckplatte angeordneten Fluidpassage zur Durchleitung eines Kühlfluides mit mindestens einem Turbulator zeichnet sich durch die Verfahrensschritte
- Zusammenpressen und Verlöten der Bauteile des Kühlkörpers durch Einschalten der Induktionsspulen der Induktionsheizvorrichtung und
- dass auf der der Grundplatte abgewandten Seite der Deckplatte und/oder auf der der Deckplatte abgewandten Seite der Grundplatte integrierte Konturen zur Fixierung und/oder Beabstandung des mindestens einen zu kühlenden Bauelements während des Lötvorgangs durch entsprechend geformte Druckplatten der Induktionsheizvorrichtung in die bei Löttemperatur erweichte Grundplatte und/oder Deckplatte eingeprägt werden,
aus, wobei zumindest ein Teil der Bauteile des Kühlkörpers durch Induktionslöten stoffschlüssig miteinander verbunden werden. Von großem Vorteil ist dabei die sehr schnelle Erwärmung der Bauteile des Kühlkörpers, so dass auf den Einsatz von Schutzmitteln oder ein Schutzgas verzichtet werden kann oder nur in minimalen Mengen eingesetzt werden muss. Die Lötzykluszeiten inklusive der Abkühlzeit bis zum Erreichen einer Festigkeit, bei der eine Weiterbearbeitung möglich ist, liegen hier im Bereich von einer bis wenigen Minuten und sind damit gegenüber herkömmlichen Lötmethoden deutlich kürzer.

Beim Einsatz einer Flüssigkeitskühlung der Induktionsheizung der Induktionslötvorrichtung kann die Abkühlung der Bauteile des Kühlkörpers deutlich verkürzt werden. Des Weiteren bewirkt eine einstellbar hohe Verpressung der Bauteile des Kühlkörpers während der Heiz- und Abkühlphase einen guten Andruck der Bauteile sowie einen Ausgleich von Form- und Maßtoleranzen der Einzelteile des Kühlkörpers. Die Kühlkörper können daher reproduzierbar sowie verzugsarm und endabmessungsnah gelötet werden.

Bedingt durch die sehr gute Flächenverlötung sind auch nachfolgende Schweißarbeiten vermeidbar. Die mit dem erfindungsgemäßen Verfahren erreichten flächig dichten Lötungen ermöglichen außerdem das Einbringen nachträglicher Gewindebohrungen im Bereich der induktionsverlöteten Flächen des Kühlkörpers.

Außerdem kann das Zusammensetzen der Bauteile des Kühlkörpers direkt in der Induktionslötvorrichtung vorgenommen werden, was zusätzlich Kosten für sonst notwendige Spannmittel erspart.

Außerdem ist das erfindungsgemäße Verfahren in einfacher Weise, beispielsweise durch Auswechseln der Druckplatten und der Gestaltung der Induktionsspulen in einfacher Weise an unterschiedliche Formgestaltungen der Kühlkörper anpassbar.

Bevorzugt können in einem Verfahrensschritt auch die in jeweilige Ausnehmungen der Grundplatte und/oder der Deckplatte eingesetzten Anschlussstutzen zusammen mit der Grundplatte und der Deckplatte induktionsverlötet werden.

Nach einer weiteren bevorzugten Ausbildung des erfindungsgemäßen Verfahrens werden vor dem Verlöten der Bauteile des Kühlkörpers die Bauteile mit einem Flussmittel beschichtet.

Zum Löten an Luftatmosphäre (z.B. in einem sogenannten Luftofen) werden üblicherweise chloridhaltige Flussmittel verwendet, die den Nachteil haben, gegenüber Aluminiumwerkstoffen korrosiv zu wirken, so dass die Bauteile nach dem Löten einer aufwendigen und kostspieligen Reinigungsprozedur durch Waschen mit Wasser unterzogen werden müssen.

Zum Löten unter einer Schutzgasatmosphäre, auch CAB (Controlled Atmospheric Brazing) genannt, wird ein Gemisch aus nicht korrosiven Fluoriden als Flussmittel verwendet, wovon nur geringe Mengen benötigt werden und keine anschließende Reinigung erforderlich ist.

Das Verlöten der Bauteile des Kühlkörpers erfolgt erfindungsgemäß unter normaler Luft-Atmosphäre.

Erstaunlicherweise hat sich bei der erfindungsgemäßen induktiven Verlötung von Kühlplatten herausgestellt, dass es möglich ist, trotz normaler Luft-Atmosphäre während des Lötprozesses, auch an offenen Strukturen wie beispielsweise den Turbulatoren in Kühlmittelpassagen, einen guten Lotfluss und somit eine gute Lötverbindung zu erreichen, wenn die Bauteile vor der Verlötung mit CAB-Flussmittel beschichtet wurden.

Nachfolgend werden Ausführungsbeispiele der Erfindung anhand der beiliegenden Zeichnungen näher erläutert.

Es zeigen:
- Figur 1: eine perspektivische Darstellung einer Ausführungsvariante eines nach dem erfindungsgemäßen Verfahren hergestellten Kühlkörpers mit Kühlmittelanschlüssen und einem auf dem Kühlkörper montierten zu kühlenden Bauelement,
- Figur 2: eine schematische Ansicht einer Induktionslötvorrichtung mit eingesetztem Kühlkörper,
- Figur 3: eine perspektivische Explosionsdarstellung des Kühlkörpers aus Figur 1,
- Figur 4: eine perspektivische Explosionsdarstellung einer weiteren Ausführungsvariante eines nach dem erfindungsgemäßen Verfahren hergestellten Kühlkörpers mit lotplattierten Zwischenblechen,
- Figur 5: eine perspektivische Darstellung einer weiteren Ausführungsvariante eines nach erfindungsgemäßen Verfahren hergestellten Kühlkörpers mit aus der Grundplatte ausgefrästem Turbulator,
- Figur 6: eine schematische Darstellung einer weiteren Ausführungsvariante eines nach dem erfindungsgemäßen Verfahren hergestellten Kühlkörpers mit gefräster Grundplatte und eingelegtem Turbulator,
- Figur 7: eine perspektivische Ansicht einer aus gestanzten und verformten, lotplattierten Blechteile bestehenden Grundplatte bzw. Deckplatte des Kühlkörpers,
- Figur 8: eine perspektivische Explosionsdarstellung einer weiteren Ausführungsvariante eines nach dem erfindungsgemäßen Verfahren hergestellten Kühlkörpers mit unter der Fluidpassage angeordneter Verteilungsplatte,
- Figur 9: eine perspektivische Ansicht einer weiteren Ausführungsvariante eines nach dem erfindungsgemäßen Verfahren hergestellten Kühlkörpers mit auf der Deckplatte eingebrachten Konturen und in die Grundplatte eingebrachte Bohrungen,
- Figur 10: eine perspektivische Explosionsdarstellung einer weiteren Ausführungsvariante eines nach dem erfindungsgemäßen Verfahren hergestellten Kühlkörpers mit in der Grundplatte integrierten Verteilungskanälen und
- Figur 11: eine perspektivische Explosionsdarstellung einer weiteren Ausführungsvariante eines nach dem erfindungsgemäßen Verfahren hergestellten Kühlkörpers mit in der Grundplatte integrierten Verteilungskanälen.

In der nachfolgenden Figurenbeschreibung beziehen sich Begriffe wie oben, unten, links, rechts, vorne, hinten usw. ausschließlich auf die in den jeweiligen Figuren ausgewählte beispielhafte Darstellung und Position des Kühlkörpers, der Grundplatte, der Deckplatte, des Turbulators und dergleichen. Diese Begriffe sind nicht einschränkend zu verstehen, d.h., durch verschiedene Arbeitsstellungen oder die spiegelsymmetrische Auslegung oder dergleichen können sich diese Bezüge ändern.

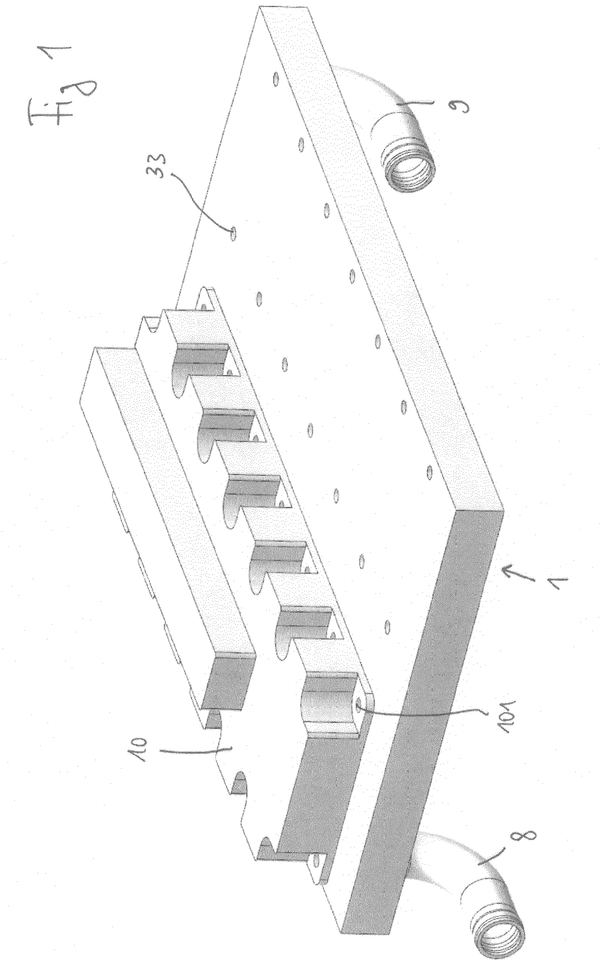

In der Figur 1 ist mit dem Bezugszeichen 1 insgesamt eine Ausführungsvariante eines nach dem erfindungsgemäßen Verfahren hergestellten Kühlkörpers bezeichnet. Der Kühlkörper 1 ist dabei bevorzugt als flächige Kühlplatte ausgebildet, auf der einer oder mehrere Bauelemente 10 befestigbar sind.

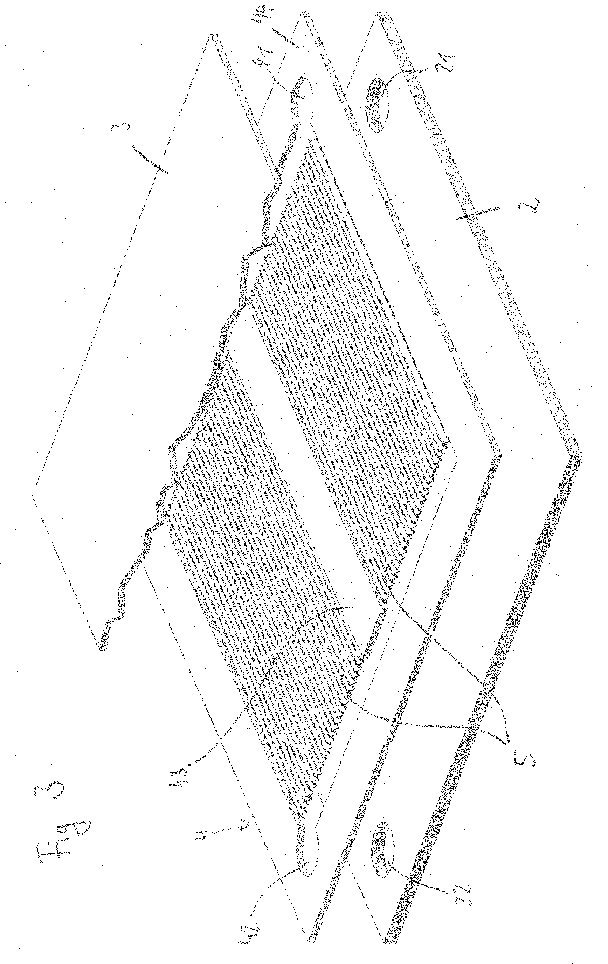

Der Kühlkörper 1 besteht dabei, wie in den Figuren 3- 8 gezeigt ist, im Wesentlichen aus einer Grundplatte 2, einer Deckplatte 3 sowie einer zwischen der Grundplatte 2 und der Deckplatte 3 angeordneten Fluidpassage 4 zur Durchleitung eines Kühlfluids, insbesondere einer Kühlflüssigkeit. In der Fluidpassage 4 ist dabei ein den Wärmeaustausch zwischen Kühlkörper 1 und Kühlfluid fördernder von dem Kühlfluid umflossener Turbulator 5 vorgesehen.

Die Grundplatte 2 sowie die Deckplatte 3 weisen dabei bevorzugt Ausnehmungen 21, 22 zur Aufnahme eines Kühlmittelanschlusses 8, 9, auf, wie in der Figur 1 beispielhaft gezeigt ist, wobei das Kühlmittel über einen der Kühlmit telanschlüsse 8, 9 in die Fluidpassage 4 eingeleitet wird, durch den Turbulator 5 oder, wie in Figur 3 gezeigt, durch mehrere nebeneinander liegende Turbulatoren 5 fließt und durch den zweiten Kühlmittelanschluss 9, 8 wieder aus dem Kühlkörper 1 austritt.

Die Fluidpassage 4 ist dabei, wie in der Explosionsdarstellung in Figur 3 gezeigt ist, gemäß einer bevorzugten Ausführungsvariante als den Turbulator 5, hier die beiden Turbulatoren 5, umgebender Rahmen 44 ausgebildet. Dabei liegen die Turbulatoren 5 vor dem induktiven Zusammenlöten auf der Bodenplatte 2 auf und werden von oben durch die Deckplatte 3 abgedeckt. Die beiden in Figur 3 gezeigten Turbulatoren 5 sind dabei durch einen Rahmenstreifen 43 voneinander getrennt. Der Rahmenstreifen 43 dient dabei neben der Auftrennung der Kühlmittelweges vor allem zur Einbringung von Bohrungen, insbesondere Gewindebohrungen, mit denen eine Bauelement 10, wie in Figur 1 gezeigt, durch Verschrauben an dem Kühlkörper 1 fixierbar ist. Außerdem dient ein solcher Rahmenstreifen 43 auch der Erhöhung der Stabilität des Kühlkörpers 1 gegenüber einem die gesamte Fläche der Fluidpassage 4 bedeckenden Turbulator 5.

Die Grundplatte 2 und die Deckplatte 3 sind hier vorzugsweise lotplattiert. Sofern die Grundplatte 2 oder die Deckplatte 3 beispielsweise aufgrund ihrer Dicke nicht lotplattiert verfügbar sind, ist es auch denkbar, auf die zu verlötenden Flächen der Bauteile des Kühlkörpers 1 eine Lotfolie oder eine Lotpaste oder dergleichen aufzubringen. Als Lote werden dabei vorzugsweise AISi 7,5 -12 Hartlote eingesetzt, ggfs. mit zusätzlichen Magnesium-Anteilen.

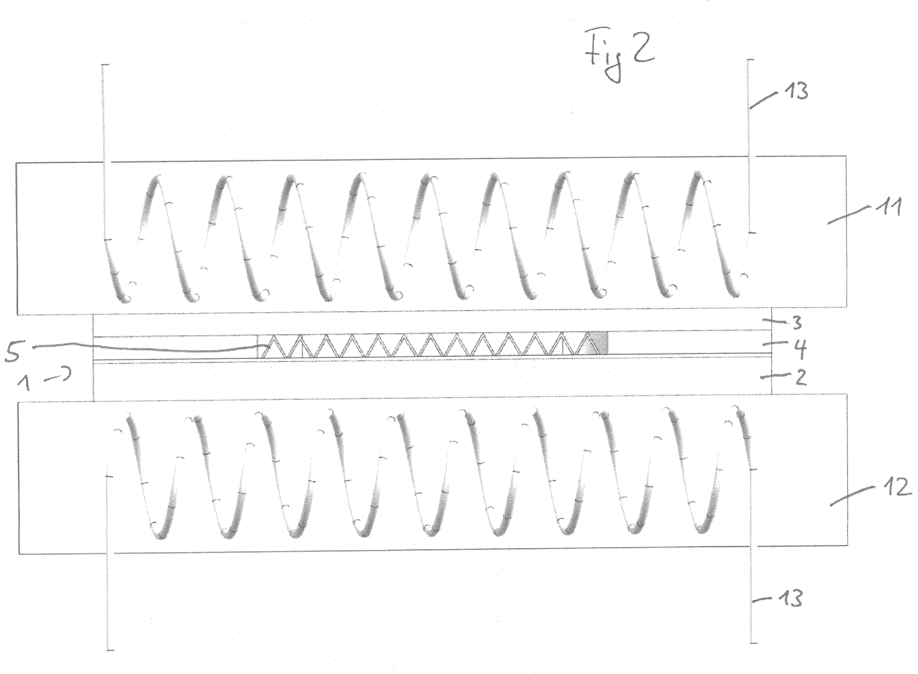

Der Induktionslötvorgang zur induktiven Verlötung des Kühlkörpers 1 ist in der Figur 2 schematisch dargestellt. Die einzelnen Bestandteile des Kühlkörpers 1, sprich im Wesentlichen die Grundplatte 2, die Deckplatte 3, die Fluidpassage 4 mit dem darin eingelegten oder integrierten Turbulator 5, werden nach dem Zusammensetzen der Bauteile des Kühlkörpers 1 in ihre vorbestimmte Position zwischen zwei Druckplatten 11, 12 in eine Induktionsheizvorrichtung eingesetzt und anschließend mithilfe der Druckplatten 11, 12 zusammengepresst. Die Druckplatten 11, 12 sind dabei mit jeweiligen Induktionsspulen, beispielsweise in Gestalt flacher spiralförmig geformter elektrischer Leiter versehen, welche mit einer Flüssigkeitskühlung zu deren Kühlung und zur Beschleunigung des sich an die Erwärmungsphase anschließenden Abkühlungsvorgangs ausgestattet sind und hinsichtlich ihrer Geometrie vorzugsweise dem zu verlötenden Kühlkörper 1 angepasst sind. Die Induktionsspulen sind dabei vorzugsweise in einen Trägerkörper, beispielsweise ein Formharz eingebettet.

Sofern die zusammengesetzten Bauteile des Kühlkörpers 1 nicht bereits lotplattiert sind, wird beim Zusammensetzen der Bauteile des Kühlkörpers 1 jeweils, wie weiter oben bereits erwähnt, ein Lot auf die zu induktionsverlötenden Bauteile des Kühlkörpers 1 aufgebracht.

Vor dem Verlöten der Bauteile des Kühlkörpers 1 werden die Bauteile vorzugsweise mit einem Flussmittel beschichtet. Dabei wird an jeder Fügestelle mindestens eines der zu verbindenden Bauteile beschichtet.
Das Flussmittel kann dabei in bekannter Art durch Tauchen, Bepinseln oder Sprühen als wässrige Schlämme mit anschließender Trocknung auf die Fügeteile appliziert werden sowie auch als lackartige Beschichtung mit Trägersubstanz (Binder) oder auch durch Plasma- oder Flammspritzen.

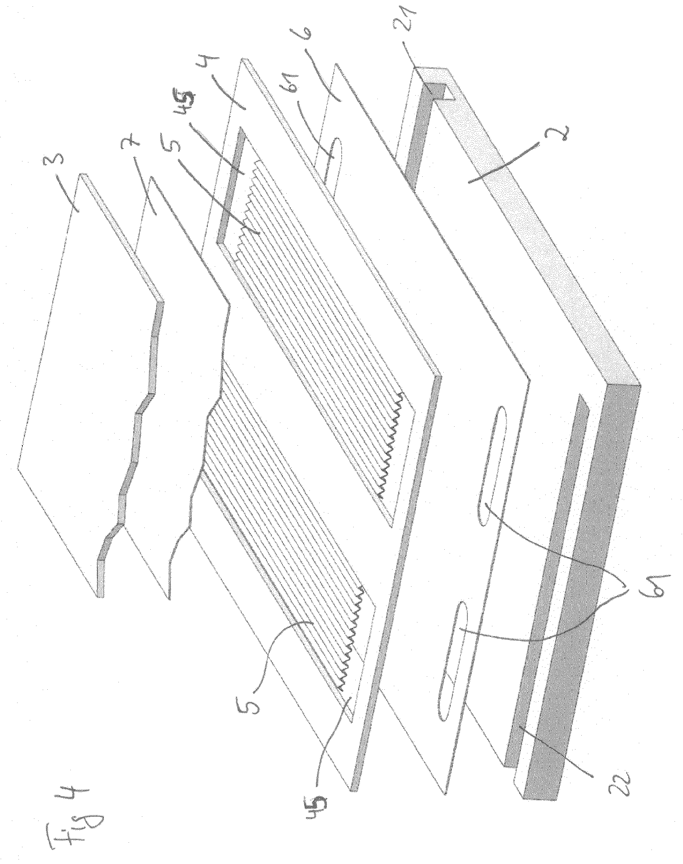

In den Figuren 4-8 sind weitere Ausgestaltungsvarianten eines erfindungsgemäßen Kühlkörpers 1 dargestellt.

So ist in Figur 4 ein Kühlkörper 1 in Explosionsdarstellung gezeigt, bei dem anstelle einer lotplattierten Grundplatte 2 und einer lotplattierten Deckplatte 3 jeweils zwischen Grundplatte 2 und Fluidpassage 4 bzw. zwischen Fluidpassage 4 und Deckplatte 3 lotplattierte Zwischenbleche 6 eingelegt sind. Dabei ist das Zwischenblech 6 zwischen der Grundplatte 2 und der Fluidpassage 4 mit Ausnehmungen 61 versehen, die im aufeinander gelegten Zustand den Durchtritt der Kühlflüssigkeit aus den Ausnehmungen 21, 22 der Grundplatte 2 gewährleisten. Die Ausnehmungen 21, 22 der Grundplatte 2 sind dabei in der hier gezeigten Ausführungsvariante als sich in Querrichtung x zur Längserstreckung der Turbulatoren 5 erstreckende Langnuten ausgebildet. Die Breite der Ausnehmungen 61 in dem lotplattierten Zwischenblech 6 längs zu den als Langnuten ausgebildeten Ausnehmungen 21, 22 der Grundplatte 2 entsprechen dabei der Breite der Ausnehmungen 45 in dem Rahmen 44 der Fluidpassage 4, in der die Turbulatoren 5 einliegen.

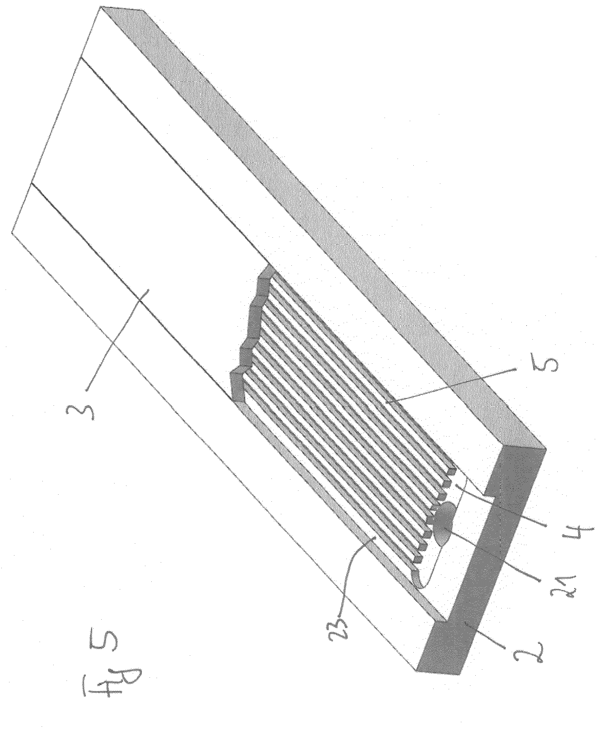

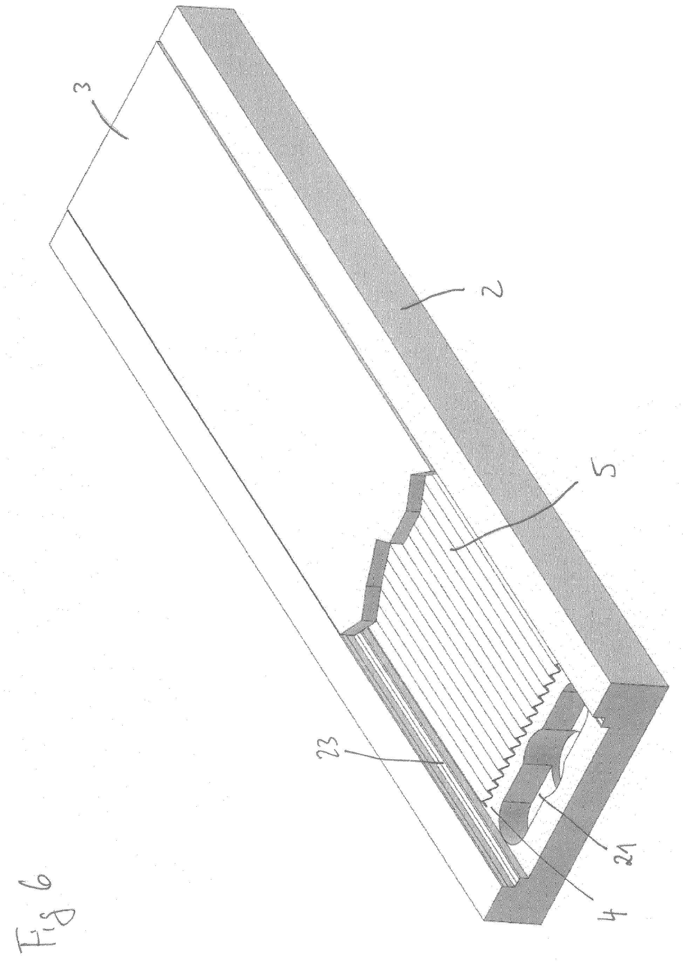

Bei den in den Figuren 5 und 6 gezeigten Ausführungsvarianten weist der Kühlkörper 1 eine vorzugsweise gefräste oder als Strangpressteil ausgebildete Grundplatte 2 auf, bei der in der in Figur 5 gezeigten Ausführungsvariante der Turbulator 5 einstückig mit der Grundplatte 2 ausgebildet, insbesondere in diese eingefräst ist.

In der in Figur 6 gezeigten Ausführungsvariante des Kühlkörpers 1 ist der Turbulator 5 in die als Fluidpassage dienende eingefräste Ausnehmung in der Grundplatte 2 eingelegt. Etwa auf Höhe der Turbulatorhöhe ist eine der Deckplatte 3 zugewandte, den Turbulator 5 umrandende Randfläche 23 an der Grundplatte 2 vorgesehen, auf die Deckplatte 3 auflegbar und in der Induktionslötvorrichtung mit der Grundplatte 2 induktionsverlötbar ist.

Der in Figur 5 gezeigte in die Grundplatte 2 eingefräste Turbulator 5 weist dabei eine Rippenstruktur mit flächiger Oberseite auf, die ebenfalls nach Auflegen der Deckplatte 3 mit dieser induktionsverlötbar ist.

Die Induktionsverlötung des Turbulators 5 mit der Grundplatte 2 erfolgt dabei vorzugsweise nach dem Auftragen einer Lotfolie oder Lotpaste.

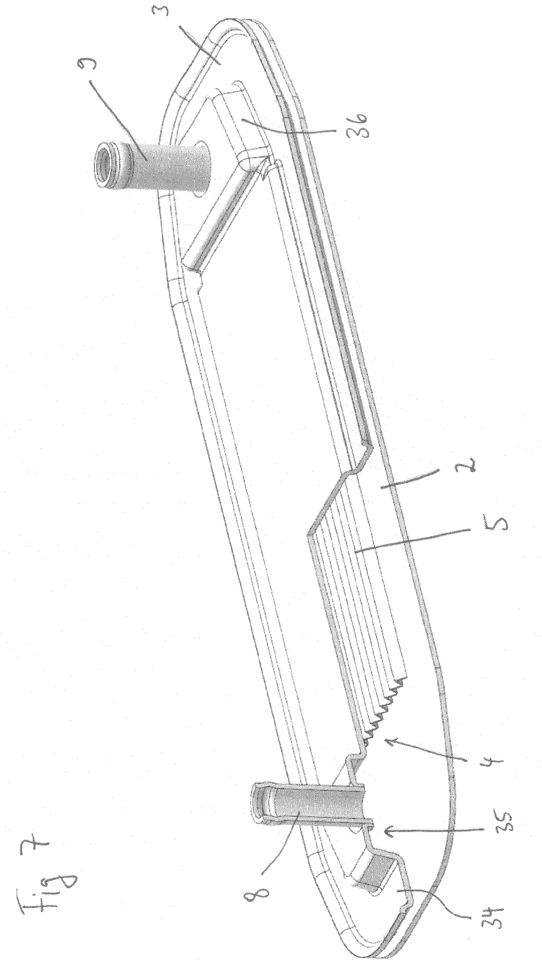

Eine weitere Ausführungsvariante eines erfindungsgemäßen Kühlkörpers 1 ist in Figur 7 dargestellt. Hier ist die Grundplatte 2 und/oder die Deckplatte 3 als gestanztes und verformtes Blechteil ausgebildet, wobei Figur 7 eine Ausführungsvariante mit gestanzter und verformter Deckplatte 3 zeigt. Die Deckplatte 3 ist dabei zu einer als Fluidkanal ausgebildeten Fluidpassage 4 mit einer Zuströmkammer 35 und einer Abströmkammer 36 geformt. In die Zuströmkammer 35 und die Abströmkammer 36 ist dabei außerdem ein Anschlussstutzen 8, 9 integriert. Die Anschlussstutzen 8, 9 können dabei ebenfalls induktiv angelötet werden, beispielsweise unter Verwendung von Lotformteilen wie Ringen oder auch unter Verwendung einer Lotpaste. In die Fluidpassage 4 unter dem nach oben gewölbten Teil der Deckplatte 3 ist wiederum ein Turbulator 5 eingelegt, welcher beispielsweise unter Verwendung einer Lotfolie mit der Grundplatte 2 induktionsverlötbar ist.

Die von der die Erhebung der Deckplatte 3 gebildete Fluidpassage 4 umgebende Vertiefung 34 ist dabei direkt mit der Grundplatte 2 induktionsverlötet und ermöglicht damit ein nachträgliche Einbringen von Schraubbohrungen zur Befestigung des in diesem Fall auf der Unterseite der Grundplatte 2 anzubringenden zu kühlenden Bauelements 10.

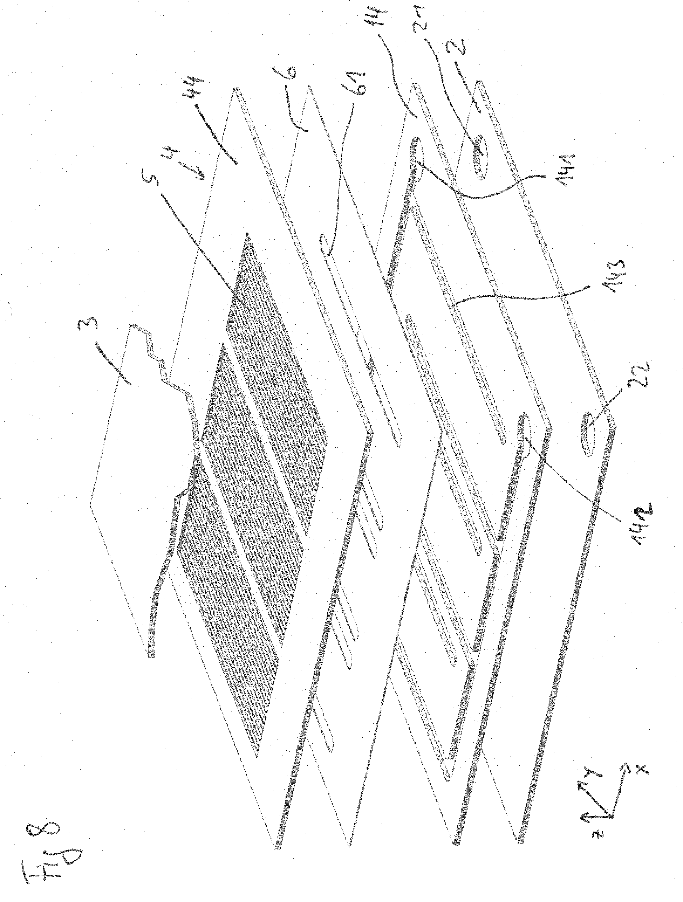

Bei der in Figur 8 gezeigten Explosionsansicht einer weiteren Ausführungsvariante eines erfindungsgemäßen Kühlkörpers 1 ist bei unter Fluidpassage 4 noch eine Verteilungsplatte 14 vorgesehen, die zur Querdurchleitung einer Richtung X quer zur Längserstreckung Y der Turbulatoren 5 eines Kühlfluids durch den mindestens einen Turbulator 5 vorgesehen ist. Die Verteilungsplatte 14 weist dazu Ausnehmungen 141, 142 zur Zuführung bzw. Abführung des Kühlfluids auf, von denen sich Kanäle 143 in Längsrichtung Y und Querrichtung X erstrecken, um bei Bedarf unterschiedliche Bereiche der Fluidpassage 4 in der wie in Figur 8 gezeigt jeweilige Turbulatoren 5 angeordnet sind separat zu durchströmen. Zur Induktionsverlötung der Verteilungsplatte 14 mit dem Rahmen 44 der Fluidpassage 4 ist ein beidseitig lotplattiertes Zwischenblech 6 mit Durchlässen 61 vorgesehen.

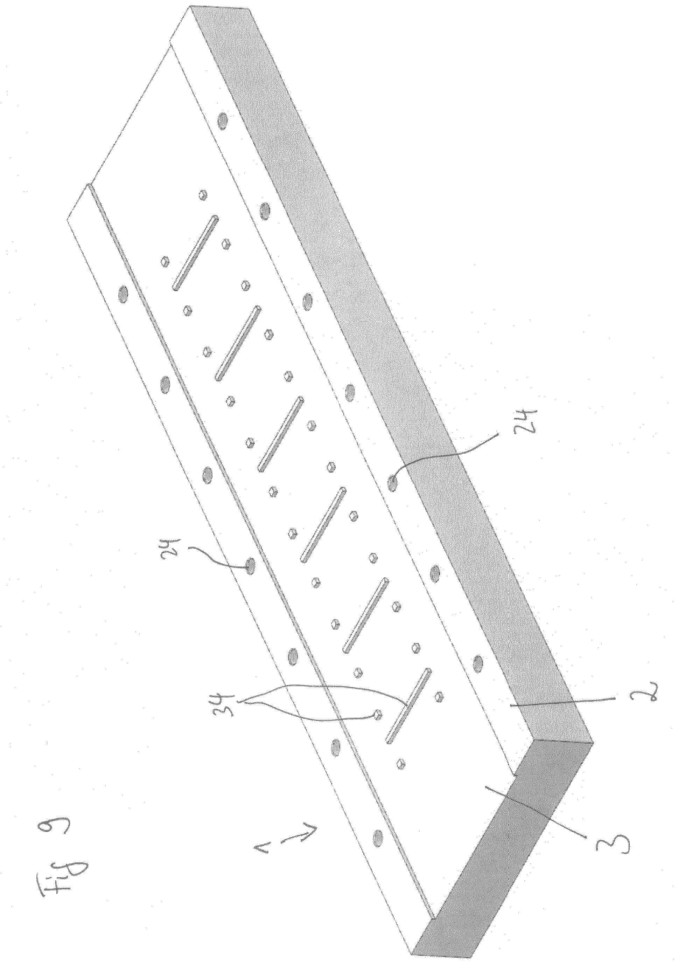

In Figur 9 ist eine Ausführungsvariante eines erfindungsgemäßen Kühlkörpers 1 mit einer den Ausführungsvarianten der Figuren 5 und 6 entsprechenden Grundplatte 2 gezeigt, deren ausgefräste Fluidpassage 4 durch eine Deckplatte 3 abgedeckt ist, die auf ihrer der Grundplatte 2 abgewandten Seite integrierte Konturen, insbesondere Erhöhungen 34 und/oder Vertiefungen zur Fixierung bzw. Beabstandung eines oder mehrerer zu kühlenden Bauelemente 10 aufweist, wobei die Konturen aufgrund des induktionsgelöteten Kühlkörpers 1 nicht aufwendig nach dem Verlöten durch Spanen oder Umformen in die Außenfläche der Deckplatte 3 eingebracht werden müssen, sondern direkt während des Lötvorgangs durch beispielsweise entsprechend geformte Druckplatten 11, 12 erfolgen kann, wobei die Druckplatten 11, 12 diese Konturen leicht in die bei Löttemperatur erweichte Deckplatte 3 eingeprägt werden kann.

Ebenfalls zu erkennen sind Bohrungen 24 entlang der die Deckplatte 3 einrahmenden Oberseite der Grundplatte 2, die wie die in Figur 1 gezeigten Bohrungen 33 bevorzugt als Schraubbohrungen ausgebildet sind, zur Befestigung des in diesem Fall auf der Oberseite der Grundplatte 2 anzubringenden zu kühlenden Bauelements 10.

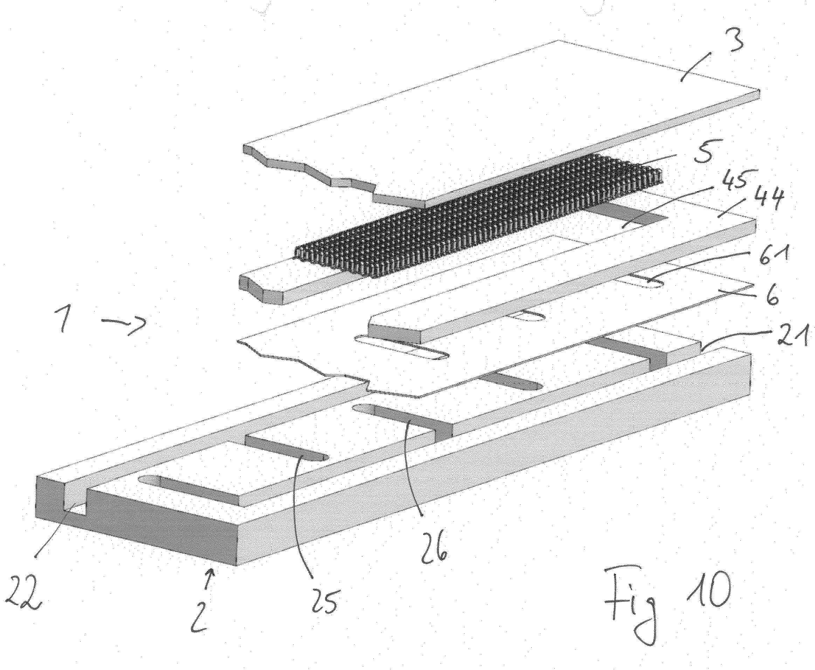

Bei der in Figur 10 gezeigten Explosionsansicht einer weiteren Ausführungsvariante eines erfindungsgemäßen Kühlkörpers 1 ist anstelle der Verteilungsplatte 14 die Grundplatte 2 mit von dem Einlasskanal 21 und dem Auslasskanal 22 abgehenden Verteilungskanälen 25 ausgebildet. Zwischen der Grundplatte 2 mit der hier kammartig ausgebildeten Struktur von Verteilungskanälen 25, 26 und der Fluidpasage 4 ist ein beidseitig lotplattiertes Zwischenblech 6 mit Durchlässen 61 vorgesehen. Der Turbulator 5 ist in einer Öffnung 45 eines Rahmens 44 der Fluidpassage 4 eingelegt und nach oben von der Deckplatte 3 abgedeckt. Das Kühlfluid kann so an einer als Einlasskanal genutzten Ausnehmung 22 in den Kühlkörper eintreten, über die Verteilungskanäle 25, 26 verteilt und nach oben durch den Turbulator 5 hindurch zur als Auslasskanal genutzten Ausnehmung 21 strömen und dort aus dem Kühlkörper 1 austreten.

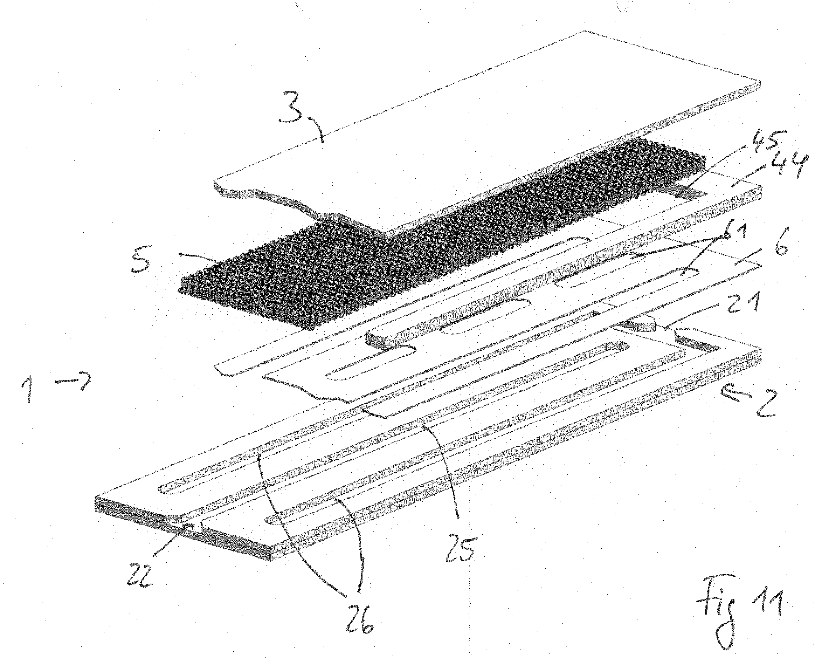

Der Turbulator 5 ist in der in Figur 10 gezeigten Ausführungsvariante des Kühlkörpers und in der weiter unten anhand Figur 11 noch näher beschriebenen weiteren Ausführungsvariante als geschnittene Offset-Lamelle ausgeführt, die aufgrund der Schnitte einen Fluiddurchtritt auch von unten und in Richtung der Wellenform des Turbulators ermöglicht. Derart aufgebaute Turbulatoren 5 sind vorzugsweise auch in den weiter oben beschriebenen Ausführungsvarianten eingesetzt.

Schließlich ist in Figur 11 eine weitere Ausführungsvariante eines erfindungsgemäßen Kühlkörpers 1 in Explosionsansicht dargestellt, die ähnlich der in Figur 10 gezeigten Ausführungsvariante ausgebildet ist. Im Unterschied zu der in Figur 10 gezeigten Ausführungsvariante sind die Verteilungskanälen 25, 26 und die als Einlass bzw. Auslass geformten Ausnehmungen 21, 22 so geformt, dass die den Einlasskanal bildende Ausnehmung 22 mittig an der Stirnseite des Kühlkörpers 1 eintritt und das Kühlfluid senkrecht zur Längserstreckung des Kühlkörpers 1 entlang des Verteilungskanals 25 über den Turbulator 5 in Richtung der parallel zum Verteilungskanal 25 angeordneten äußeren Verteilungskanälen 26 und von dort in Richtung der ebenfalls mittig an der gegenüberliegenden Stirnseite des Kühlkörpers 1 angeordneten, als Auslasskanal genutzten, Ausnehmung 21 strömt.

Denkbar ist auch, die in Figur 11 gezeigten Verteilungskanäle 25, 26 als Verteilungsplatte auf die Grundplatte 2 aufzusetzen und miteinander induktiv zu verlöten.

Mit den in den Figuren 10 und 11 gezeigten Ausführungsvarianten des Kühlkörpers ist eine gezielte Einleitung des noch kalten Kühlfluids möglichst nah an die Stellen größter abzuführender Verlustwärme der Bauelemente 10 ermöglicht, so dass alle Bauelemente 10 gleich stark gekühlt werden können. Dadurch lässt sich eine ungleichmäßige Entwärmung infolge einer hydraulischen Reihenschaltung mit sukzessive steigenden Kühlfluidtemperaturen unter den Bauelementen 10 vermeiden.

### Bezugszeichenliste

- 1: Kühlkörper
- 2: Grundplatte
- 21: Ausnehmung
- 22: Ausnehmung
- 23: Randfläche
- 24: Bohrung
- 25: Verteilungskanal
- 26: Verteilungskanal

- 3: Deckplatte
- 31: Ausnehmung
- 32: Ausnehmung
- 33: Bohrung
- 34: Vertiefung
- 35: Zuströmkammer
- 36: Abströmkammer

- 4: Fluidpassage
- 41: Ausnehmung
- 42: Ausnehmung
- 43: Rahmenstreifen
- 44: Rahmen
- 45: Ausnehmung

- 5: Turbulator

- 6: Zwischenblech
- 61: Durchlass

- 7: Zwischenblech
- 8: Kühlmittelanschluss
- 9: Kühlmittelanschluss

- 10: Bauelement
- 101: Bohrung
- 11: Druckplatte
- 12: Druckplatte
- 13: Induktionsspule

- 14: Verteilungsplatte
- 141: Ausnehmung
- 142: Ausnehmung
- 143: Verteilungskanal

- x: Querrichtung
- y: Längsrichtung
- z: Vertikalrichtung

## Patentansprüche

1. Verfahren zur Herstellung eines Kühlkörpers (1) mit zumindest einer Grundplatte (2), eine Deckplatte (3) sowie eine zwischen der Grundplatte (2) und der Deckplatte (3) angeordnete Fluidpassage (4) zur Durchleitung eines Kühlfluids mit mindestens einem Turbulator (5), wobei zumindest ein Teil der Bauteile des Kühlkörpers (1) durch Induktionslöten stoffschlüssig miteinander verbunden werden, mit den Verfahrensschritte:
- Zusammensetzen der Bauteile des Kühlkörpers (1) in ihre vorbestimmte Position,
- Einsetzen des Kühlkörpers (1) zwischen jeweilige Druckplatten (11, 12) einer Induktionsheizvorrichtung,
**dadurch gekennzeichnet, dass**
- die Fluidpassage (4) mindestens einen Turbulator aufweist und dass das Verfahren die weiteren Verfahrensschritte aufweist:
- Zusammenpressen und Verlöten der Bauteile des Kühlkörpers (1) durch Einschalten der Induktionsspulen (13) der Induktionsheizvorrichtung und
- dass auf der der Grundplatte (2) abgewandten Seite der Deckplatte (3) und/oder auf der der Deckplatte (3) abgewandten Seite der Grundplatte (2) integrierte Konturen zur Fixierung und/oder Beabstandung des mindestens einen zu kühlenden Bauelements (10) während des Lötvorgangs durch entsprechend geformte Druckplatten (11, 12) der Induktionsheizvorrichtung in die bei Löttemperatur erweichte Grundplatte (2) und/oder Deckplatte (3) eingeprägt werden.

2. Verfahren nach Anspruch 1, aufweisend den weiteren Verfahrensschritt:
- Aufbringen eines Lotes auf die zu induktionsverlötenden Bauteile des Kühlkörpers (1).

3. Verfahren nach einem der vorstehenden Ansprüche, wobei in jeweilige Ausnehmungen (21, 22, 31, 32) der Grundplatte (2) und/oder der Deckplatte (3) eingesetzte Anschlussstutzen (8, 9) zusammen mit der Grundplatte (2) und der Deckplatte (3) induktionsverlötet werden.

4. Verfahren nach einem der vorstehenden Ansprüche, wobei vor dem Verlöten der Bauteile des Kühlkörpers (1) die Bauteile mit einem Flussmittel beschichtet werden.

5. Verfahren nach Anspruch 4, wobei ein nicht korrosives Flussmittel eingesetzt wird und das Verlöten der Bauteile des Kühlkörpers (1) unter normaler Luftatmosphäre erfolgt.

## Claims

1. A method for producing a heatsink (1) comprising at least one base plate (2), a cover plate (3), and a fluid passage (4) arranged between the base plate (2) and the cover plate (3) for conducting through a coolant fluid, comprising at least one turbulator (5), wherein at least a part of the components of the heatsink (1) are connected to one another in an integrally-joined manner by induction soldering, comprising the following method steps:
- assembling the components of the heatsink (1) in the predetermined position thereof,
- inserting the heatsink (1) between respective pressure plates (11, 12) of an induction heating device,
**characterized in that**
- the fluid passage (4) comprises at least one turbulator, and the method comprises the following further method steps:
- pressing together and soldering the components of the heatsink (1) by switching on the induction coils (13) of the induction heating device, and
- on the side of the cover plate (3) facing away from the base plate (2) and/or on the side of the base plate (2) facing away from the cover plate (3), integrated contours for fixing and/or spacing apart the at least one structural element (10) to be cooled are embossed during the soldering procedure, by way of correspondingly formed pressure plates (11, 12) of the induction heating device, into the base plate (2) and/or the cover plate (3), which are softened at soldering temperature.

2. The method according to Claim 1, comprising the following further method steps:
- applying a solder to the components of the heatsink (1) to be induction soldered.

3. The method according to any one of the preceding claims, wherein connection fittings (8, 9) inserted into respective recesses (21, 22, 31, 32) of the base plate (2) and/or the cover plate (3) are induction soldered together with the base plate (2) and the cover plate (3).

4. The method according to any one of the preceding claims, wherein before the soldering of the components of the heatsink (1), the components are coated using a flux.

5. The method according to Claim 4, wherein a noncorrosive flux is used and the soldering of the components of the heatsink (1) takes place under normal air atmosphere.

## Revendications

1. Procédé de fabrication d'un dissipateur thermique (1) comportant au moins une plaque de base (2), une plaque de recouvrement (3) et un passage de fluide (4) disposé entre la plaque de base (2) et la plaque de recouvrement (3) pour faire passer un fluide de refroidissement avec au moins un turbulateur (5), au moins certains composants du dissipateur thermique (1) étant reliés entre eux par liaison de matière par brasage par induction, comprenant les étapes consistant à :
- assembler les composants du dissipateur thermique (1) dans leur position prédéterminée,
- insérer le dissipateur thermique (1) entre les plaques de pression respectives (11, 12) d'un dispositif de chauffage par induction,
**caractérisé en ce que**
- le passage de fluide (4) présente au moins un turbulateur et que le procédé présente les étapes supplémentaires consistant à :
- comprimer et braser les composants du dissipateur thermique (1) par activation des bobines d'induction (13) du dispositif de chauffage par induction et
- que, sur le côté de la plaque de recouvrement (3) opposé à la plaque de base (2) et/ou sur le côté de la plaque de base (2) opposé à la plaque de recouvrement (3), des contours intégrés destinés à fixer et/ou espacer ledit au moins un élément (10) à refroidir pendant le brasage sont imprimés dans la plaque de base (2) et/ou la plaque de recouvrement (3) ramollie à la température de brasage par des plaques de pression (11, 12) de forme correspondante du dispositif de chauffage par induction.

2. Procédé selon la revendication 1, comprenant l'étape supplémentaire consistant à :
- appliquer un métal d'apport de brasage sur les composants du dissipateur thermique (1) à braser par induction.

3. Procédé selon l'une des revendications précédentes, dans lequel des tubulures de raccordement (8, 9) insérées dans des évidements respectifs (21, 22, 31, 32) de la plaque de base (2) et/ou de la plaque de recouvrement (3) sont brasées par induction avec la plaque de base (2) et la plaque de recouvrement (3).

4. Procédé selon l'une des revendications précédentes, dans lequel les composants du dissipateur thermique (1) sont revêtus d'un flux avant d'être brasés.

5. Procédé selon la revendication 4, dans lequel un flux non corrosif est utilisé et les composants du dissipateur thermique (1) sont brasés sous une atmosphère d'air normale.
